Europäisches Patentamt

European Patent Office

Office européen des brevets

(19)

(11) Numéro de publication : **0 402 249 B1**

(12)

# FASCICULE DE BREVET EUROPEEN

(45) Date de publication du fascicule du brevet :
06.10.93 Bulletin 93/40

(51) Int. Cl.[5] : **H01S 3/137**

(21) Numéro de dépôt : **90401538.5**

(22) Date de dépôt : **06.06.90**

(54) **Laser à semi-conducteur stabilisé en longueur d'onde.**

(30) Priorité : **08.06.89 FR 8907595**

(43) Date de publication de la demande :
**12.12.90 Bulletin 90/50**

(45) Mention de la délivrance du brevet :
**06.10.93 Bulletin 93/40**

(84) Etats contractants désignés :
**DE GB NL**

(56) Documents cités :
**US-A- 3 774 120**
**US-A- 4 573 156**

(56) Documents cités :
**APPLIED PHYSICS LETTERS, vol. 49, no. 25, décembre 1986, pages 1686-1688, New York, US; W.T. TSANG et al.: "Observation of enhanced single longitudinal mode operation in 1.5-mum GaInAsP erbium-doped semiconductor injection lasers"**
**APPLIED PHYSICS LETTERS, vol. 50, no. 22, juin 1987, pages 1567-1568, New York, US; G. EISENSTEIN et al.: "High-power extended-cavity laser at 1.3 mum with a single-mode fiber output port"**

(73) Titulaire : **FRANCE TELECOM**
**6, Place d'Alleray**
**F-75015 Paris (FR)**

(72) Inventeur : **Auzel, François**
**11, Place Levitt**
**F-78320 Le Mesnil Saint Denis (FR)**

(74) Mandataire : **Mongrédien, André et al**
**c/o BREVATOME 25, rue de Ponthieu**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un laser à semi-conducteur stabilisé en longueur d'onde.

Elle trouve une application en télécommunications optiques. Elle s'applique à tous les lasers à semi-conducteur et notamment aux lasers à simple ou double hétérostructure en alliage III-V. Il peut s'agir par exemple, mais non exclusivement, de lasers à GaAs, GaAlAs, InGaAs, GaAsP, InGaAsP, InP, etc...

Dans le domaine des télécommunications optiques, il existe un réel besoin de sources laser offrant une grande stabilité de fréquence. Ce n'est qu'à cette condition qu'on pourra mettre en oeuvre les techniques de la radioélectricité comme la modulation, la démodulation, etc...

La stabilisation en fréquence des lasers en général et des lasers à semi-conducteur en particulier, est une technique largement connue aujourd'hui. Plusieurs solutions ont été proposées : asservissement de la fréquence à un mode de résonance d'un étalon Fabry-Pérot ou à une raie d'absorption d'un gaz, synchronisation sur un autre laser, lui-même stabilisé, etc...

Pour faciliter l'obtention de cette stabilité, le laser à stabiliser est choisi ou modifié pour présenter déjà une certaine stabilité de fréquence. On peut ainsi opérer par tri de doubles hétérostructures pour ne retenir que les composants dont l'alliage conduit à la fréquence centrale souhaitée ; il est également possible de réduire la largeur propre d'émission en allongeant la cavité résonnante au moyen d'un miroir auxiliaire extérieur (contre-réaction optique) ; on peut enfin avoir recours à un réseau de diffraction disposé le long de la zone active (laser dit "DFB" pour "Distributed Feed-Back" ou encore "DBR" pour "Distributed Bragg Reflection").

Cet état de la technique est décrit par exemple dans l'article de Motoichi OHTSU intitulé "Frequency Stabilization in Semi-Conductor Lasers" publié dans la revue "Optical and Quantum Electronics", vol. 20, (1988), pages 283-300.

Cependant, ces techniques connues présentent des inconvénients. La méthode du tri des hétérostructures conduit à des rendements de fabrication bas. Le recours à la contre-réaction optique par miroir auxiliaire externe pose des problèmes mécaniques difficiles et conduit à des structures complexes et lourdes de mise en oeuvre. Quant aux lasers à réseaux distribués le long de la zone active, ils ne sont obtenus qu'au prix d'une complication des procédés de fabrication, due à des reprises d'épitaxie.

La présente invention a justement pour but de remédier à tous ces inconvénients. A cette fin, elle propose un moyen de stabilisation particulièrement simple à mettre en oeuvre et qui évite tous les écueils de l'art antérieur.

Selon l'invention, on ajoute à la cavité du laser à stabiliser un cristal dopé en ions de terre rare. On rappelle à ce sujet que de tels ions possèdent un état fondamental et un premier état électronique excité. Du fait du champ électrique créé par le réseau cristallin, ces niveaux sont décomposés en sous-niveaux (effet Stark). Les ions présentent alors des séries de raies d'absorption correspondant à des transitions de l'état fondamental vers l'état excité et des raies d'émission correspondant à des transitions inverses. Ces deux séries de raies sont légèrement décalées l'une par rapport à l'autre, les raies d'émission se situant à une énergie un peu plus faible, donc à une longueur d'onde un peu plus grande.

On a déjà pensé à utiliser les terres rares dans les lasers à semi-conducteurs. L'article de W.T. TSANG et al. intitulé "Observation of enhanced single longitudinal mode of operation in 1.5 $\mu$m GaInAsP erbium-doped semiconductor injection lasers" publié dans la revue "Applied Physics Letters", vol. 49, (25), 22 décembre 1986, pp. 1686-1688, décrit une technique consistant à introduire les ions de terre rare dans la zone active du laser.

En réalité, une telle manière de procéder conduit à des difficultés. Tout d'abord, il est difficile d'introduire des terres rares dans les semi-conducteurs (concentration maximum de l'ordre de $10^{16}$-$10^{18}$ cm$^{-3}$) car elles ont tendance à y précipiter. On obtient en fait une cavité multiple aléatoire, qui donne bien un fonctionnement monofréquence mais à une fréquence imprévisible. Par ailleurs, l'instabilité en température observée par les auteurs W.T. TSANG et al. reste élevée : $\Delta\lambda/\Delta T = 1,1$Å/°C, ($1$Å$=10^{-10}$m.) ce qui montre bien que ce ne sont pas les ions terre rare qui stabilise l'émission car l'instabilité propre à ces ions est beaucoup plus faible et de l'ordre de $10^{-2}$Å/°C.

L'inventeur de la présente invention a bien montré (dans un article publié dans la revue Journal of Applied Physics, vol. 66, 3952, 1989) que les ions terre rare ne rentrant qu'en faible concentration dans le semi-conducteur (cas de Yb$^{3+}$) ou restant à l'extérieur de celui-ci (cas de Er$^{3+}$), les gains obtenus à la fréquence de la transition de la terre rare sont négligeables ($10^{-1}$ à $10^{-2}$cm$^{-1}$) devant ceux du semi-conducteur (environ $10^{2}$cm$^{-1}$). Il n'y a donc guère de modification de ce gain par l'adjonction d'ions terre rare.

Un article de VAN DER ZIEL publié dans la revue Applied Physics Letters, vol. 50, 1313, 1987 a confirmé qu'il fallait remettre en cause les interprétations données préalablement dans l'article de W.T. TSANG.

La présente invention permet de remédier à tous ces inconvénients. Elle permet d'utiliser des concentrations d'ions de terre rare beaucoup plus importantes que dans l'art antérieur ($10^{20}$ à $10^{22}$cm$^{-3}$), ce qui permet de modifier considérablement le gain du semi-conducteur et de bénéficier véritablement de la grande stabilité en longueur d'onde de la transition de l'ion terre rare (instabilité de l'ordre de $10^{-2}$Å/°C).

Ce résultat est obtenu grâce à l'invention en utilisant un cristal dopé en ions terre rare disposé en dehors du semi-conducteur. Les ions terre rare ne sont donc plus situés dans le milieu actif semi-conducteur.

Selon l'invention, on choisit la composition du cristal et la nature des ions pour que l'une des transitions de l'ion terre rare (absorption et/ou émission) tombe dans la bande d'émission spontanée du milieu amplificateur semi-conducteur. Il se produit alors un transfert d'énergie des plus courtes longueurs d'onde vers les plus grandes longueurs d'onde, comme on le comprendra mieux par la suite. La transition de l'ion terre rare se trouve être privilégiée et c'est sur la longueur d'onde de cette transition que le laser va osciller.

De façon précise, la présente invention a pour objet un laser à semi-conducteur comprenant un milieu amplificateur à jonction semi-conductrice et au moins un miroir, la jonction étant réunie à une source de courant et présentant une bande d'émission spontanée, ce laser étant caractérisé par le fait qu'il comprend en outre, pour le stabiliser en longueur d'onde, un cristal dopé avec des ions de terre rare ayant une transition tombant dans la bande d'émission spontanée du milieu amplificateur, ce cristal étant disposé entre le miroir et le milieu amplificateur, le laser émettant alors à une longueur d'onde correspondant à la transition de l'ion terre rare.

La valeur de la longueur d'onde stabilisée dépend d'abord de l'ion de terre rare utilisé, et dans une mesure moindre du réseau cristallin, lequel impose un champ électrique aux ions, déplaçant ainsi les niveaux par effet Stark. L'intensité du champ cristallin peut ainsi varier de plus d'un facteur 3 entre $NdCl_3$ et $Y_3Al_5O_{12}$:Nd par exemple.

Ainsi, pour ce qui est de l'ion terre rare, on pourra utiliser :

- $Sm^{2+}$ pour une longueur d'onde voisine de 0,65 µm à 0,7 µm,
- $Nd^{3+}$, $Yb^{3+}$ pour une longueur d'onde voisine de 0,81 µm à 1 µm,
- $Tm^{2+}$ pour une longueur d'onde voisine de 1,2 µm,
- $Er^{3+}$ pour une longueur d'onde voisine de 1,5 µm,
- $Tm^{3+}$, $Ho^{3+}$ pour une longueur d'onde voisine de 2 µm.

Pour ce qui est du cristal, une grande variété de matériaux est possible. On peut citer : $Y_3Al_5O_{12}$, $LaCl_3$, $LaF_3$, $LaP_5O_{14}$, $CaWO_4$, $LiYF_4$, $Na_5La(WO_4)_4$, $LiLaP_4O_{12}$, $KLaP_4O_{12}$, etc...

Les propriétés des cristaux dopés en ions de terre rare sont étudiées dans un article de l'inventeur de la présente invention, F. AUZEL, article intitulé "A Scalar Crystal Field Parameter for Rare Earth Ions ; Meaning and Application to Energy Transfer", publié dans l'ouvrage "Energy Transfer Processes in Condensed Matter", édité par B. Di BARTOLO, (PLENNUM), 1984.

Selon une autre disposition avantageuse de l'invention, on donne au cristal une forme telle qu'il produise une sélection de mode. En donnant au cristal stabilisateur la forme d'une lame mince apte à jouer le rôle d'étalon Fabry-Pérot, cet étalon pourra ne présenter qu'un seul mode longitudinal dans la raie atomique. En d'autres termes, l'intervalle spectral libre, donné classiquement par la formule c/2nL où c est la vitesse de la lumière, n l'indice du cristal et L l'épaisseur de la lame, devra être proche de ou supérieure à la largeur $\Delta F$ de la raie d'émission de l'ion de terre rare.

On s'efforcera donc de prendre une épaisseur L supérieure ou égale à c/2n $\Delta F$.

Pour n=1,5, $\Delta F$=1cm$^{-1}$, on obtient une épaisseur L de 1 mm.

Selon une autre disposition avantageuse de l'invention, on utilise plusieurs cristaux de composition différente dopés avec la même terre rare. Pour les raisons évoquées plus haut, on obtiendra plusieurs longueurs d'onde priviligiées. Le laser sera alors multilongueur d'onde et trouvera une application en multiplexage optique.

De toute façon, les caractéristiques de l'invention apparaîtront mieux à la lumière de la description qui va suivre. Cette description porte sur des exemples non limitatifs et se réfère à des dessins annexés sur lesquels :

- la figure 1 montre schématiquement un spectre d'absorption-émission d'un ion terre rare dans un cristal,
- la figure 2 montre la courbe de gain d'un milieu aplificateur semi-conducteur et celle d'un ensemble composite comprenant un amplificateur semi-conducteur et un cristal dopé stabilisateur,
- la figure 3 illustre un premier mode de réalisation d'un laser conforme à l'invention,
- la figure 4 illustre un deuxième mode de réalisation d'un laser conforme à l'invention,
- la figure 5 illustre un troisième mode de réalisation d'un laser conforme à l'invention.

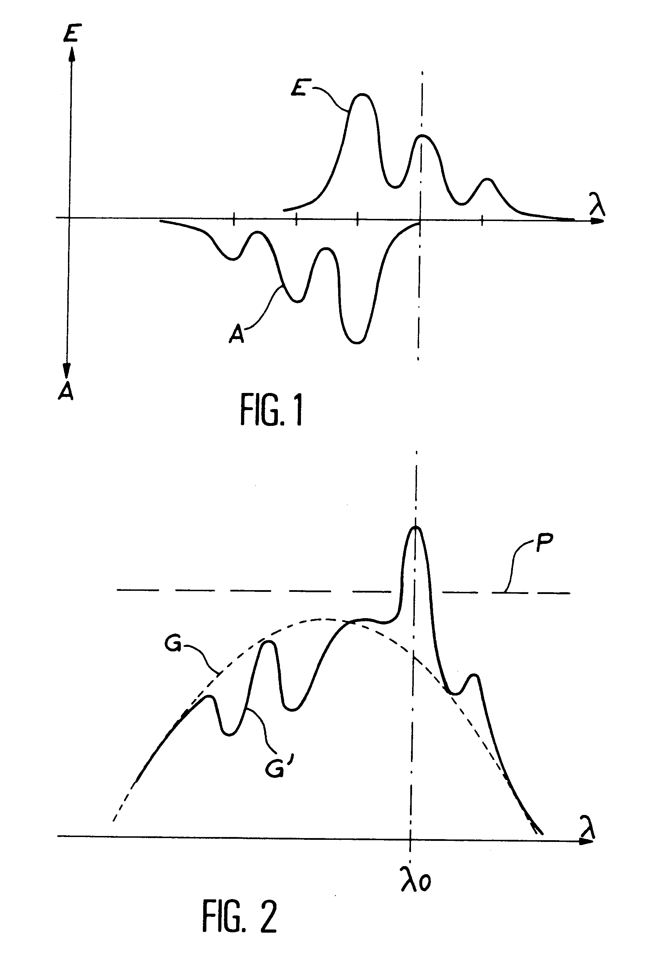

On a représenté sur la figure 1, de manière schématique, le spectre d'absorption (A) d'un cristal dopé avec des ions terre rare et le spectre d'émission (E). L'axe des abscisses correspond à la longueur d'onde. Les pics d'absorption correspondent aux différentes transitions atomiques de l'état fondamental (séparé par effet Stark) vers le premier état électronique excité (également séparé par effet Stark) et les pics d'émission aux transitions de l'état excité vers l'état fondamental. Le décalage vers les grandes longueurs d'onde de l'émission par rapport à l'absorption est classique (effet Stokes).

Un cristal ainsi dopé, placé dans la cavité d'un laser, va modifier le gain du milieu amplificateur selon le schéma de la figure 2. La courbe de gain G représente les variations du gain en fonction de la longueur d'onde pour un milieu amplificateur à semi-conducteur classique. La présence du cristal dopé diminue le gain dans la zone d'absorption et l'augmente dans la zone d'émission pour donner une courbe G′ qui est, grosso modo, au-dessous de la courbe G pour les basses longueurs d'onde et au-dessus de G pour les plus grandes longueurs d'onde.

Si le résonateur présente des pertes P, l'oscillation ne sera possible que pour la longueur d'onde où le gain l'emportera sur ces pertes. L'oscillation se produira ainsi à la longueur d'onde λo, qui n'est plus définie par le sommet de la courbe de gain du milieu amplificateur à semi-conducteur, avec toutes les fluctuations qui peuvent en résulter, mais par la raie d'émission propre à l'ion terre rare, avec la stabilité qu'on connaît aux raies atomiques.

L'invention n'est pas limitée au fonctionnement sur une raie d'émission telle que la raie à λo représentée, mais s'étend au cas de toute transition de l'ion terre rare. A bas niveau d'excitation, même la partie "négative" de la courbe de gain peut être utilisée pour stabiliser le laser.

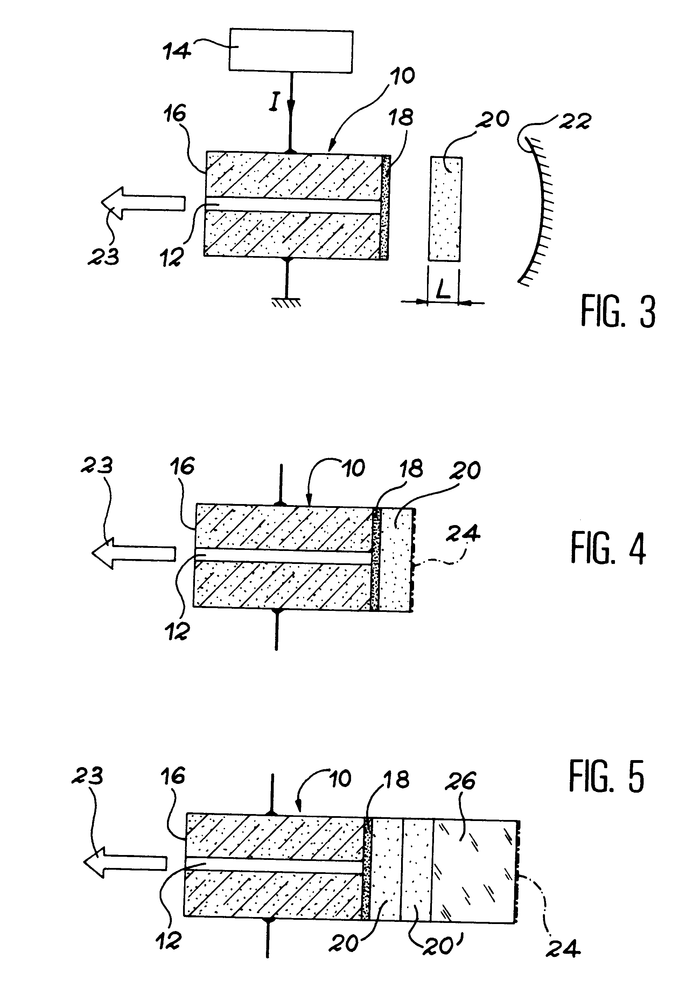

Les figures 3 à 5 montrent quelques exemples de réalisation de lasers conformes à l'invention.

Le laser illustré sur la figure 3 comprend un milieu amplificateur 10 en forme de double hétérostructure avec jonction PN référencée 12. La structure semi-conductrice est alimentée en courant par une source 14. La face avant 16 de l'hétérostructure est clivée. La face arrière est recouverte d'une couche anti-reflet 18. Une lame mince 20 de cristal dopé en ions de terre rare est disposée entre la couche anti-reflet 18 et un miroir sphérique 22. L'émission cohérente stabilisée en longueur d'onde s'effectue par l'avant (référence 23).

Dans une variante plus compacte illustrée par la figure 4, la lame mince cristalline dopée 20 est plaquée sur la couche anti-reflet 18 et une couche réfléchissante 24 est déposée sur la face arrière de la lame.

La variante illustrée sur la figure 5 diffère des précédentes par l'utilisation d'une fibre optique 26 disposée entre la lame cristalline 20 et la couche réfléchissante 24. Cette fibre est avantageusement autofocalisante. Sur cette figure, on a représenté en outre une deuxième lame 20′ faite d'un cristal différent de celui de la lame 20 mais dopée par les mêmes ions.

A titre d'exemple non limitatif, on va décrire un laser conforme à l'invention émettant sur un seul mode longitudinal ("monomode" ou "monofréquence") stabilisé à 1,5335 μm.

Le milieu amplificateur est constitué d'une double hétérostructure en alliage quaternaire dont la zone active est en InGaAsP. L'émission naturelle d'une telle structure se situe entre 1,480 et 1,525 μm selon la composition. La structure est stabilisée par un cristal de $LiYF_4$ dopé à l'erbium, de formule $LiY_{1-x}Er_xF_4$ où x est compris entre $10^{-4}$ et 1. La valeur de x dépend à la fois de la puissance disponible dans la cavité, de l'épaisseur de la lame cristalline et de la concentration en ions $Er^{3+}$. Plus la puissance est importante et plus x peut s'écarter de l'unité et plus l'épaisseur du cristal peut être choisie faible.

De façon plus précise, dans le cas d'une absorption uniforme dans le cristal stabilisateur on a la relation approchée :

$$\phi LN > \frac{1}{2T} \frac{hF}{sr}$$

où

T désigne la durée de vie du niveau excité de la terre rare et est pris égal à 10 ms,

F est la fréquence, soit $2 \times 10^{14} s^{-1}$ pour une longueur d'onde de 1,54 μm,

s est la section efficace d'absorption et est prise égale à $10^{-20} cm^{-2}$,

$\phi$ est le flux optique incident sur le cristal en $Wcm^{-2}$,

N est la densité d'ions,

L est l'épaisseur du cristal stabilisateur,

h est la constante de Planck,

r est le rendement quantique qui peut être pris égal à l'unité.

Le second membre de l'inégalité est donc sensiblement égal à $6,6 \times 10^{22}$ $(Wcm^{-4})$.

a) En prenant x=1, on a $N=1,4 \times 10^{22} cm^{-3}$ ; en conséquence, L doit être supérieur à $5Wcm^{-1}$.

Pour un laser ayant une puissance de 5mW dans la cavité, avec une zone active de 50 μmx0,1 μm, soit $5.10^{-3} (μm)^2$, le flux sera de $10^5 W/cm^2$. L'épaisseur L du cristal devra donc être supérieure à $5.10^{-5} cm$, soit supérieure à un demi micromètre.

Cet exemple montre que si le cristal stabilisateur a une grande concentration en ions de terre rare, il peut être très mince (0,5 μm) et constitué par exemple d'une couche disposée sur la face anti-reflet de l'hétérostructure. Mais la qualité du matériau ainsi déposé peut laisser à désirer et le rendement quantique diminuer.

On peut donc préférer choisir une concentration en ions plus faible (x inférieur à 1).

b) A l'autre extrémité de la plage offerte à x on peut choisir x=0,001, ce qui correspond à $N=1,4 \times 10^{19} cm^{-3}$ et, avec les mêmes hypothèses sur la puissance, l'épaisseur L doit alors être supérieure à 100 μm.

Si le flux lumineux correspond à une puissance 10 fois plus faible, l'épaisseur L devient au minimum égale à 1000 μm.

Si l'on veut simultanément que la lame cristalline agisse comme sélecteur de mode longitudinal, il conviendra de ne pas lui donner une épaisseur supérieure à la valeur qui donne à l'intervalle spectral libre la valeur de la largeur de raie d'émission, à savoir sensiblement 3,3 cm$^{-1}$. On a vu que l'épaisseur limite est de l'ordre du millimètre.

c) Entre ces deux extrêmes (x=1 et x=0,001), on pourra prendre par exemple x=0,1, soit N=1,4x10$^{21}$cm$^{-3}$, ce qui donne une épaisseur de L=0,3 mm.

Une telle lame mince peut être obtenue par polissage. On dépose sur l'une de ses faces une couche d'or réfléchissante destinée à jouer le rôle de miroir à haute réflectivité à la longueur d'onde de 1,5335 μm. La face arrière de la double hétérostructure en InGaAsP est traitée anti-reflet par une couche de SiO produisant une réflexion inférieure à 10$^{-2}$. L'assemblage selon la figure 4 s'effectue à l'aide de collages minces de manière à ne pas détruire le parallélisme des surfaces. Des colles de type cyanoacrylate ou époxy dites "pour optiques IR" conviennent bien.

## Revendications

1. Laser à semi-conducteur comprenant un milieu amplificateur (10) à jonction semi-conductrice (12) et au moins un miroir (22), la jonction (12) étant réunie à une source de courant (14) et présentant une bande d'émission spontanée, ce laser étant caractérisé en ce qu'il comprend en outre, pour le stabiliser en longueur d'onde, un cristal dopé avec des ions de terre rare ayant une transition tombant dans la bande d'émission spontanée du milieu amplificateur, ce cristal (20) étant disposé entre le miroir (22) et le milieu amplificateur (10), le laser émettant alors à une longueur d'onde correspondant à la transition de l'ion terre rare.

2. Laser à semi-conducteur selon la revendication 1, caractérisé par le fait que les ions terre rare sont choisis dans le groupe constitué par :
   - Sm$^{2+}$ pour une longueur d'onde voisine de 0,65 μm à 0,7μm,
   - Nd$^{3+}$, Yb$^{3+}$ pour une longueur d'onde voisine de 0,81 μm à 1 μm,
   - Tm$^{2+}$ pour une longueur d'onde voisine de 1,2 μm,
   - Er$^{3+}$ pour une longueur d'onde voisine de 1,5 μm,
   - Tm$^{3+}$, Ho$^{3+}$ pour une longueur d'onde voisine de 2 μm.

3. Laser à semi-conducteur selon la revendication 1, caractérisé par le fait que le cristal est pris dans le groupe constitué par LiYF$_3$, Y$_3$Al$_5$O$_{12}$, LaCl$_3$, LaF$_3$, LaP$_5$O$_{14}$, CaWO$_4$, LiYF$_4$, Na$_5$La(WO$_4$)$_4$, LiLaP$_4$O$_{12}$, KLaP$_4$O$_{12}$.

4. Laser à semi-conducteur selon les revendications 2 et 3, caractérisé par le fait que le cristal dopé est de formule LiY$_{1-x}$Er$_x$F$_4$ où x est compris entre 0 et 1 (borne inférieure exclue).

5. Laser à semi-conducteur selon la revendication 1, caractérisé par le fait que le cristal dopé présente la forme d'une lame mince (20) découpée dans un monocristal, cette lame mince constituant un étalon Fabry-Pérot ayant une épaisseur inférieure à la valeur donnant à cet étalon un intervalle spectral libre de l'ordre de la largeur de raie d'émission de l'ion terre rare.

6. Laser à semi-conducteur selon la revendication 1, caractérisé par le fait que le cristal dopé présente la forme d'une couche mince.

7. Laser à semi-conducteur selon la revendication 1, caractérisé par le fait que le milieu amplificateur (10) comprend une hétérostructure ayant une face clivée (16) et une face recouverte d'une couche anti-reflet (18), le cristal (20) étant disposé entre la couche anti-reflet (18) et le miroir (22).

8. Laser à semi-conducteur selon la revendication 7, caractérisé par le fait que le cristal (20) est au contact avec la couche anti-reflet (18).

9. Laser à semi-conducteur selon la revendication 7, caractérisé par le fait que le cristal dopé (20) est au contact avec le miroir (24).

10. Laser à semi-conducteur selon la revendication 8, caractérisé par le fait qu'il comprend en outre une fibre optique (26) entre le cristal dopé (20) et le miroir (24).

11. Laser à semi-conducteur selon la revendication 1, caractérisé par le fait qu'il comprend plusieurs cristaux (20, 20') de nature chimique différente mais contenant les mêmes ions terre rare, le laser étant alors stabilisé sur plusieurs longueurs d'onde.

## Patentansprüche

1. Halbleiterlaser umfassend einen Mittelpunktverstärker (10) mit halbleitender Verbindung (12) und mindestens einen Spiegel (22), wobei der Übergang (12) mit einer Stromquelle (14) verbunden ist und ein spontanes Emissionsband darstellt, dieser Laser ist dadurch gekennzeichnet, daß er unter anderem, um ihn in der Wellenlänge zu stabilisieren, ein mit Ionen seltener Erden dotiertes Kristall enthält dessen Übergang in das spontane Emissionsband des Mittelpunktverstärkers fällt, dieses Kristall (20) ist zwischen dem Spiegel (22) und dem Mittelpunktverstärker (10) angeordnet, der Laser emittiert dann eine dem Übergang der Ionen der seltenen Erden entsprechende Wellenlänge.

2. Halbleiterlaser nach Anspruch 1, dadurch gekennzeichnet, daß die Ionen der seltenen Erden ausgewählt sind aus der Gruppe bestehend aus:
   - $Sm^{2+}$ für eine Wellenlänge nahe 0,65 μm bis 0,7 μm,
   - $Nd^{3+}$, $Yb^{3+}$ für eine Wellenlänge nahe 0,81 μm bis 1 μm,
   - $Tm^{2+}$ für eine Wellenlänge nahe 1,2 μm,
   - $Er^{3+}$ für eine Wellenlänge nahe 1,5 μm,
   - $Tm^{3+}$, $Ho^{3+}$ für eine Wellenlänge nahe 2 μm.

3. Halbleiterlaser nach Anspruch 1, dadurch gekennzeichnet, daß das Kristall entnommen ist aus der Gruppe bestehend aus $LiYF_3$, $Y_3Al_5O_{12}$, $LaCl_3$, $LaF_3$, $LaP_5O_{14}$, $CaWO_4$, $LiYF_4$, $Na_5La(WO_4)_4$, $LiLaP_4O_{12}$, $KLaP_4O_{12}$.

4. Halbleiterlaser nach Ansprüchen 2 und 3, dadurch gekennzeichnet, daß das dotierte Kristall der Formel $LiY_{1-x}Er_xF_4$ entspricht, wobei x zwischen 0 und 1 liegt (unterer Anschluß ausgenommen).

5. Halbleiterlaser nach Anspruch 1, dadurch gekennzeichnet, daß das dotierte Kristall die Form eines aus einem Monokristall geschnittenen dünnen Streifens hat, wobei dieser, einen Fabry-Pérot-Standard bildende, dünne Streifen eine geringere Stärke hat, als der Wert welcher diesem Standard einen freien Spectral Intervall in der Größenordnung der emittierten Streifenbreite der Ionen der seltenen Erden gibt.

6. Halbleiterlaser nach Anspruch 1, dadurch gekennzeichnet, daß das dotierte Kristall eine dünne Schicht bildet.

7. Halbleiterlaser nach Anspruch 1, dadurch gekennzeichnet, daß der Mittelpunktverstärker (10) eine Heterostruktur mit einer gespaltenen Seite (16) und eine mit einer nicht reflektierenden Schicht (18) überzogene Seite umfaßt, wobei das Kristall (20) zwischen der nicht reflektierenden Schicht (18) und dem Spiegel (22) angeordnet ist.

8. Halbleiterlaser nach Anspruch 7, dadurch gekennzeichnet, daß das Kristall (20) in Kontakt mit der nicht reflektierenden Schicht (18) ist.

9. Halbleiterlaser nach Anspruch 7, dadurch gekennzeichnet, daß das dotierte Kristall (20) in Kontakt mit dem Spiegel (24) ist.

10. Halbleiterlaser nach Anspruch 8, dadurch gekennzeichnet, daß er unter anderem eine optische Faser (26) zwischen dem dotierten Kristall (20) und dem Spiegel (24) umfaßt.

11. Halbleiterlaser nach Anspruch 1, dadurch gekennzeichnet, daß er mehrere Kristalle (20, 20') von chemisch unterschiedlicher Natur, jedoch dieselben Ionen der seltenen Erden enthaltend, umfaßt, der Laser ist dann auf mehreren Wellenlängen stabilisiert.

## Claims

1. Semiconductor laser including an amplifier medium (10) with a semiconductive junction (12) and at least one mirror (22), the junction (12) being joined to a current source (14) and having one spontaneous emission band, characterized in that to wavelength-stabilize the same, it further includes a crystal doped with rare earth ions having a transition within the spontaneous emission band of the amplifier medium, said crystal (20) being disposed between the mirror (22) and the amplifier medium (10), the laser then transmitting on a wavelength corresponding to the transition of the rare earth ion.

2. Semiconductor laser according to claim 1, characterized in that the rare earth ions are selected from the group constituted by:
   - $Sm^{2+}$ for a wavelength of between 0.65 μm and 0.7 μm,
   - $Nd^{3+}$, $Yb^{3+}$ for a wavelength of between 0.81 μm and 1 μm,
   - $Tm^{2+}$ for a wavelength of about 1.2 μm,
   - $Er^{3+}$ for a wavelength of about 1.5 μm,
   - $Tm^{3+}$, $Ho^{3+}$ for a wavelength of about 2 μm.

3. Semiconductor laser according to claim 1, characterized in that the crystal is taken from the group constituted by $LiYF_3$, $Y_3 Al_5 O_{12}$, $LaCl_3$, $LaF_3$, $LaP_5 O_{14}$, $CaWO_4$, $LiYF_4$, $Na_5La(WO_4)_4$. LiLaP_4 O_{12}$, $KLaP_4 O_{12}$.

4. Semiconductor laser according to claims 2 and 3, characterized in that the formula of the doped crystal is $LiY_{1-x}Er_x F_4$ where x is between 0 and 1 (lower limit excluded).

5. Semiconductor laser according to claim 1, characterized in that the doped crystal has the shape of a thin plate (20) cut from a monocrystal, this thin plate constituting a Fabry-Pérot standard having a thickness less than the value giving this standard a free spectral interval of about the width of the emission line of the rare earth ion.

6.  Semiconductor laser according to claim 1, characterized in that the doped crystal has the shape of a thin plate.

7.  Semiconductor laser according to claim 1, characterized in that the amplifier medium (10) includes a heterostructure having one split face (16) and one face covered with an anti-reflection coating (18), the crystal (20) being disposed between the coating (18) and the mirror (22).

8.  Semiconductor laser according to claim 7, characterized in that the crystal (20) is in contact with the anti-reflection coating (18).

9.  Semiconductor laser according to claim 7, characterized in that the doped crystal (20) is in contact with the mirror (24).

10. Semiconductor laser according to claim 8, characterized in that it further includes an optical fibre (26) disposed between the doped crystal (20) and the mirror (24).

11. Semiconductor laser according to claim 1, characterized in that it includes several crystals (20,20') having a different chemical nature, but containing the same rare earth ions, the laser then being stabilized on several wavelengths.

EP 0 402 249 B1

FIG. 1

FIG. 2

FIG. 3

FIG. 4

FIG. 5